# EUROPÄISCHE PATENTSCHRIFT

(11) **EP 2 520 023 B1**
(45) Veröffentlichungstag und Bekanntmachung des Hinweises auf die Patenterteilung: **03.09.2014**
(21) Anmeldenummer: 10803461.2
(22) Anmeldetag: 30.12.2010
(51) Int. Cl.: H03K 17/955, H03K 17/96, B60N 2/00

(54) **KAPAZITIVE SENSORBAUGRUPPE**
CAPACITIVE SENSOR ASSEMBLY
MODULE DE DÉTECTION CAPACITIF

(30) Priorität: 30.12.2009 DE 102009055426
(43) Veröffentlichungstag der Anmeldung: 07.11.2012
(73) Patentinhaber: Takata AG, 63743 Aschaffenburg (DE)
(72) Erfinder: KANDLER, Marcus, 63639 Flörsbachtal (DE)
(74) Vertreter: Baumgärtel, Gunnar
(86) Internationale Anmeldenummer: PCT/EP2010/070938
(87) Internationale Veröffentlichungsnummer: WO 2011/080324

(56) Entgegenhaltungen:
- EP-B1- 1 301 800
- US-A1- 2006 022 682
- US-A1- 2007 089 527
- US-A1- 2007 117 445

## Beschreibung

Die Erfindung betrifft eine kapazitive Sensorbaugruppe für ein Kraftfahrzeug nach dem Oberbegriff des Patentanspruchs 1.

Eine derartige kapazitive Sensorbaugruppe umfasst zumindest ein kapazitives Sensorelement, das durch mindestens ein (erstes) elektrisches Leiterelement als Elektrode gebildet wird und das an eine Auswerteeinheit angeschlossen bzw. anzuschließen ist, welche mindestens eine Messgröße in Abhängigkeit von der kapazitiven Ankopplung des kapazitiven Sensorelementes an die Umgebung erfasst und auswertet, sowie zumindest ein (potentialführendes) elektrisches Referenzleiterelement, das ein elektrisches Referenzpotential (Nullpotential) bei der Bestimmung jener Messgröße bzw. allgemeiner bei der kapazitiven Ankopplung des kapazitiven Sensorelementes an die Umgebung bildet bzw. definiert und das von dem kapazitiven Sensorelement, also insbesondere von dem ersten elektrischen Leiterelement, beabstandet angeordnet ist. Der Begriff Leiterelement wird dabei vorliegend allgemein für ein ein- oder mehrteiliges elektrisch leitfähiges Element verwendet, das z.B. als Kabel, als Flachleiter, als elektrisch leitfähige Folie oder in sonstiger Form als elektrisch leitfähiges Bauelement (elektrisch leitfähige Baugruppe) ausgeführt sein kann.

Die zugeordnete Auswerteeinheit kann insbesondere die Änderung einer Messgröße (z.B. eines Messstromes) in Abhängigkeit von der kapazitiven Ankopplung des kapazitiven Sensorelementes an ein Referenzpotential, welches durch ein geeignetes Fahrzeugelement, wie z.B. Komponenten der Fahrzeugkarosserie, Komponenten eines Fahrzeugsitzes oder das erwähnte elektrische Heizelement, definiert sein kann, erfassen und auswerten, wobei diese kapazitive Ankopplung und damit jene Messgröße durch die Anwesenheit eines Fahrzeuginsassen oder eines sonstigen Objektes in der Umgebung des kapazitiven Sensorelementes beeinflusst wird. Im Fall eines in einen Fahrzeugsitz integrierten kapazitiven Sensorelementes kann hiermit z.B. die Anwesenheit eines auf dem Sitz befindlichen Fahrzeuginsassen erfasst werden und auch auf dessen Konstitution rückgeschlossen bzw. ein Kindersitz erkannt werden.

Aus der US 6,563,231 B1 ist es bekannt, zur Bildung eines kapazitiven Sensorelementes auf einer Sensormatte mindestens ein elektrisches Leiterelement als Elektrode vorzusehen. Die Sensormatte wird als Insassendetektor an einem Fahrzeugteil angeordnet, um die Belegung eines bestimmten Sitzplatzes eines Kraftfahrzeugs mit einem Fahrzeuginsassen feststellen zu können. Konkret wird die Sensormatte mit dem als kapazitivem Sensorelement dienenden elektrischen Leiterelement beispielsweise an einer Sitzfläche eines Kraftfahrzeugsitzes angeordnet, und zwar insbesondere zwischen dem Sitzbezug und einem Sitzpolster, also etwa unterhalb des Sitzüberzugs und oberhalb des Polsterschaums. Um zu ermitteln, ob sich ein Fahrzeuginsasse auf einem mit einem solchen Detektor ausgerüsteten Fahrzeugsitz befindet, wird die Kapazität zwischen der Sensormatte und einem Träger eines Referenzpotentials (Nullpotential), etwa definiert durch den Fahrzeugboden ("Erde") oder durch mindestens ein in die Sensormatte integriertes Referenzleiterelement, bestimmt. Dies muss keineswegs zwingend direkt durch eine (unmittelbare) Kapazitätsmessung erfolgen; sondern es kann durch die Messung beliebiger elektrischer Größen geschehen, die mit der genannten Kapazität verknüpft sind, deren jeweiliger Messwert also von der Kapazität (zwischen der Sensormatte und einem Träger des Referenzpotentials) abhängt, wie z.B. durch die Messung von Messströmen (in bzw. zu dem als kapazitivem Sensorelement dienenden elektrischen Leiterelement), vergl. auch DE 100 48 956 C1 im Fall einer Lenkradintegrierten kapazitiven Sensorbaugruppe.

Befindet sich ein Fahrzeuginsasse auf dem entsprechenden Fahrzeugsitz, so wird die resultierende Kapazität beeinflusst durch die kapazitive Ankopplung des Insassen; und die resultierende Kapazität entspricht einer Kombination (je nach den konkreten Gegebenheiten z.B. näherungsweise einer Reihenschaltung) der Kapazität zwischen der Sitzoberfläche (bzw. dem dort vorgesehenen kapazitiven Sensorelement) und dem Fahrzeuginsassen sowie der Kapazität zwischen dem Fahrzeuginsassen und dem Referenzpotential. Indem dabei ein Referenzleiterelement mit Referenzpotential als Gegenelektrode in den Fahrzeugsitz bzw. in die Sensormatte selbst integriert wird, lässt sich der Abstand zwischen dem Träger des Referenzpotentials und dem zu detektierenden Fahrzeuginsassen reduzieren und hierdurch die Messempfindlichkeit verbessern.

Mit einer solchen Anordnung kann auch unterschieden werden, ob sich auf dem entsprechenden Fahrzeugsitz unmittelbar ein Fahrzeuginsasse befindet oder ob auf dem Fahrzeugsitz ein Kindersitz angebracht ist, der wiederum ein Kleinkind aufnimmt. Diese Feststellung kann genutzt werden, um gegebenenfalls, z.B. bei Nichtbelegung oder bei Belegung mit einem Kindersitz, einen oder mehrere dem entsprechenden Sitzplatz zugeordnete Airbags zu deaktivieren. Somit kann eine kapazitive Sensorbaugruppe als Insassendetektor verwendet werden, um Sicherheitseinrichtungen eines Kraftfahrzeugs zu aktivieren oder deaktivieren, aber auch zum Auslösen sonstiger Funktionen eines Kraftfahrzeugs, wie z. B. von Warn- oder Steuerungsfunktionen.

Weiterhin ist es aus der Praxis bekannt, auf einer Sensormatte neben mindestens einem als Sensorelement dienenden elektrischen Leiterelement zusätzlich elektrisch betriebene Heizleiter anzuordnen, die von dem ersten elektrischen Leiterelement beabstandet angeordnet sind und die bei Bestromung Wärme zur Beheizung eines Lenkrades, eines Fahrzeugsitzes oder eines sonstigen Fahrzeugteiles erzeugen.

Bei kapazitiven Sensorsystemen, die neben einem kapazitiven Sensorelement auch mindestens ein elektrisches Heizelement und/oder mindestens ein Referenzleiterelement umfassen, ist die Einhaltung eines definierten Abstandes zwischen dem das kapazitive Sensorelement bildenden (ersten) elektrischen Leiterelement sowie den das elektrische Heizelement bildenden Heizleitern bzw. dem jeweiligen Referenzleiterelement von Bedeutung, um zuverlässige Aussagen über die Belegung eines Sitzplatzes mit einem Fahrzeuginsassen gewinnen zu können. Insbesondere ist auch die Auswirkung von Feuchtigkeit und Nässe auf die Messergebnisse abhängig vom Abstand zwischen Sensorelement und Heizelement bzw. Sensorelement und Referenzleiterelement.

Das Dokument US 2007/0089527 A1 offenbart eine kapazitive Sensorbaugruppe nach dem Oberbegriff des Anspruchs 1.

Weitere kapazitive Sensorbaugruppen sind aus den Dokumenten US 2007/0117445 A1 und US 2006/0022682 A1 bekannt.

In dem Dokument EP 1 301 800 B1 wird ein kapazitiver Insassensensor zum Erfassen eines Insassen in einem Sitz beschrieben, wobei der Sitz ein leitfähiges Heizelement umfasst.

Der Erfindung liegt das Problem zugrunde, eine kapazitive Sensorbaugruppe für ein Kraftfahrzeug zu schaffen, die die vorgenannten Nachteile vermeidet.

Dieses Problem wird erfindungsgemäß durch die Schaffung einer kapazitiven Sensorbaugruppe mit den Merkmalen des Patentanspruchs 1 gelöst.

Danach ist das ein kapazitives Sensorelement bildende erste elektrische Leiterelement der Sensorbaugruppe als (längserstreckter) Außenleiter ausgeführt und umgibt das (ein elektrisches Referenzpotential definierende) elektrische Referenzleiterelement, welches einen Innenleiter bildet (und entlang der - ggf. gekrümmten - Erstreckungsrichtung des Außenleiters verläuft), wobei zwischen dem ersten Leiterelement als Außenleiter und dem Referenzleiterelement als Innenleiter ein weiteres, zweites Leiterelement verläuft, wobei das erste und zweite Leiterelement und das Referenzleiterelement einen Triaxialkabelaufbau bilden.

Hierdurch wird in einfacher Weise eine definierte Anordnung eines ein kapazitives Sensorelement bildenden ersten elektrischen Leiterelementes bezüglich eines Referenzleiterelementes erreicht, wobei die Anordnung gezielt entweder so ausgelegt werden kann, dass der Abstand zwischen dem ersten elektrischen Leiterelement (Außenleiter) und dem Referenzleiterelement (Innenleiter) im Betrieb stets konstant bleibt, oder so ausgelegt werden kann, dass in Abhängigkeit von bestimmten äußeren Verhältnissen, wie z. B. einer Druckeinwirkung, definierte Abstandsänderungen ermöglicht werden. Das Referenzleiterelement ("potentialführendes Element") definiert dabei insbesondere (als Gegenelektrode zu dem ersten Leiterelement) jeweils ein Referenzpotential für (Kapazitäts-)Messungen.

Zur Schaffung definierter Verhältnisse kann insbesondere vorgesehen sein, dass das erste Leiterelement das Referenzleiterelement in einer Querschnittsebene der Sensorbaugruppe, die das erste Leiterelement und das Referenzleiterelement (z.B. im Wesentlichen senkrecht bezogen auf die Erstreckungsrichtung von erstem Leiterelement und Heizleiter) schneidet, vollständig umgibt, also in Form einer in der Querschnittsebene geschlossenen Kurve umschließt.

Für eine umfassende Einsetzbarkeit der Sensorbaugruppe, z.B. um nicht nur die Anwesenheit einer Person in der Umgebung feststellen zu können, sondern etwa Aussagen über die Konstitution der Person machen zu können oder eine Sitzbelegung durch einen Kindersitz erkennen zu können, können das Referenzleiterelement und das erste Leiterelement derart voneinander beabstandet sein, dass jede beliebige Gerade, welche sich in der Querschnittsebene der Sensorbaugruppe erstreckt, die das erste Leiterelement und das Referenzleiterelement (z.B. im Wesentlichen senkrecht) schneidet, unabhängig von der räumlichen Orientierung der Geraden in der Querschnittsebene, durch Parallelverschiebung in der Querschnittsebene in eine Lage bringbar ist, in der sie eine Kurvensekante des ersten Leiterelementes bildet, ohne das Referenzleiterelement zu schneiden.

Das Referenzleiterelement ("potentialführendes Element"/Innenleiter) kann nach einer Weiterbildung gleichzeitig als elektrischer Heizleiter (zum Beheizen einer Fahrzeugkomponente) dienen und ist hierfür mit einem geeigneten elektrischen Strom ("Heizstrom") zu betreiben.

Nach einer vorteilhaften Ausführungsform der Erfindung bildet das erste elektrische Leiterelement als Außenleiter eine längliche Hülle, in der sich das Referenzleiterelement als (länglicher) Innenleiter erstreckt. Ein solcher Aufbau lässt sich insbesondere nach Art eines geschirmten Leiters bzw. eines Koaxialkabels realisieren, mit dem Referenzleiterelement als Seele und dem ersten Leiterelement als äußerer Hülle.

Das erste Leiterelement in Form eines Außenleiters kann dabei - ebenso wie gegebenenfalls das Referenzleiterelement in Form eines Innenleiters - durch ein Leitungsgeflecht, eine elektrisch leitende Folie oder dergl. gebildet werden.

Das zweite Leiterelement kann insbesondere dazu dienen, das erste Leiterelement (Außenleiter) und das Referenzleiterelement (Innenleiter) gegeneinander abzuschirmen. Hierzu kann das zweite Leiterelement einen sogenannten potentialgesteuerten Schirm ("driven shield") bilden.

Das (hüllenartig) zwischen dem inneren Referenzleiterelement und dem äußeren ersten Leiterelement verlaufende zweite Leiterelement kann ebenfalls als Leitungsgeflecht, elektrisch leitende Folie oder dergl. ausgebildet sein.

Dabei sind vorteilhaft das Referenzleiterelement und das zweite Leiterelement derart voneinander beabstandet, dass jede beliebige Gerade, welche sich in der Querschnittsebene der Sensorbaugruppe erstreckt, die das erste und zweite Leiterelement sowie das Referenzleiterelement (z.B. im Wesentlichen senkrecht) schneidet, unabhängig von der räumlichen Orientierung der Geraden in der Querschnittsebene, durch Parallelverschiebung in der Querschnittsebene in eine Lage bringbar ist, in der sie eine Kurvensekante des zweiten Leiterelementes bildet, ohne das Referenzleiterelement zu schneiden. Dies entspricht der Beabstandung, die vorstehend bereits für das Referenzleiterelement und das erste Leiterelement angegeben wurde.

Vorteilhaft ist das Referenzleiterelement als innerer Leiter von einem Dielektrikum umgeben, das durch ein Gas, wie z. B. Luft, aber auch durch einen (isolierenden) Festkörper gebildet sein kann.

Gemäß einer Variante ist das Dielektrikum unter Einwirkung eines äußeren Druckes komprimierbar, so dass die Konfiguration der Sensoranordnung gezielt druckabhängig veränderbar ist, was wiederum die resultierende Kapazität beeinflusst und Rückschlüsse auf Druckverhältnisse im Bereich der Sensoranordnung ermöglicht. So kann als Dielektrikum ein Material verwendet werden, das sich unter einem äußeren Druck, der einen bestimmten Mindestdruck überschreitet, substantiell verformt, woraus etwa Rückschlüsse auf das Gewicht eines Fahrzeuginsassen gezogen werden können, der auf einem mit der Sensoranordnung ausgerüsteten Fahrzeugsitz Platz genommen hat. Neben einer Unterscheidung zwischen schwereren und leichteren Fahrzeuginsassen, die für die Wahl eines bestimmten Aufblasverhaltens eines Airbags von Bedeutung sein kann, lässt sich hiermit insbesondere die Unterscheidung zwischen einer Belegung mit einem Kindersitz und einem (kleinen) Fahrzeuginsassen unterstützen.

Nach einer Weiterbildung kann die Deformierbarkeit des Dielektriums ortsabhängig sein, etwa indem zur Bildung des das Referenzleiterelement umgebenden Dielektrikums in verschiedenen Bereichen unterschiedliche Materialien verwendet werden.

Nach einer anderen Variante wird als Dielektrikum ein Material verwendet, das bei den im Normalbetrieb der Sensoranordnung auftretenden Drücken, also beispielsweise im Fall einer fahrzeugsitzintegrierten Sensoranordnung unter den von Fahrzeuginsassen erzeugten Drücken, nicht substantiell deformierbar ist. Hierdurch wird sichergestellt, dass (Kapazitäts-)Messungen druckunabhängige Ergebnisse liefern.

Zum Schutz der Sensorbaugruppe und insbesondere eines das Referenzleiterelement umgebenden Dielektrikums vor Feuchtigkeit kann eine (isolierende) Schutzhülle vorgesehen sein, die zumindest das Referenzleiterelement als inneren Leiter (sowie gegebenenfalls ein das Referenzleiterelement umschließendes Dielektrikum) umhüllt. Eine solche Schutzhülle kann beispielsweise zwischen dem ersten Leiterelement als Außenleiter und dem Referenzleiterelement als Innenleiter verlaufen oder auch jenseits des Außenleiters; sie kann aber auch (alternativ oder zusätzlich) an der äußersten Oberfläche der Sensorbaugruppe verlaufen. Die Schutzhülle kann durch ein zusätzliches Hüllenelement gebildet oder unmittelbar in die Anordnung integriert sein, z.B. in Form eines Isolierlackes.

Insbesondere kann das erste Leiterelement mit einem Wechselstrom (als Messstrom) beaufschlagt werden, um durch Auswertung des Realteiles, des Imaginärteiles und/oder des Effektivwertes des Stromes auch bei Nässe zuverlässige Resultate zu ermöglichen.

Die erfindungsgemäße Sensorbaugruppe kann insbesondere Bestandteil eines Kraftfahrzeugsitzes sein, um eine Sitzbelegung erkennen zu können; oder sie kann Bestandteil eines Lenkrades sein, um eine Handauflage eines Fahrzeugführers am Lenkrad feststellen zu können. Schließlich kann sie auch in ein Sicherheitsgurtsystem eines Kraftfahrzeugs oder in eine andere Fahrzeugbaugruppe integriert sein.

Weitere Einzelheiten und Vorteile der Erfindung werden bei der nachfolgenden Beschreibung von Ausführungsbeispielen anhand der Figuren deutlich werden.

Es zeigen:
- Fig. 1: eine schematische Darstellung eines Kraftfahrzeugsitzes mit einer Sensormatte, die mindestens ein kapazitives Sensorelement enthält;
- Fig. 2: ein erstes Beispiel eines elektrischen Leiters zur Bildung eines kapazitiven Sensorelementes;
- Fig. 3: ein Ausführungsbeispiel eines elektrischen Leiters zur Bildung eines kapazitive Sensorelementes;
- Fig.4: ein kapazitives Sensorelement zusammen mit einer zugeordneten Auswerteeinheit;
- Fig. 5: ein zweites Beispiel eines elektrischen Leiters zur Bildung eines kapazitive Sensorelementes;
- Fig. 6: einen schematischen Querschnitt durch ein Kraftfahrzeug-Lenkrad mit kapazitivem Sensorelement.

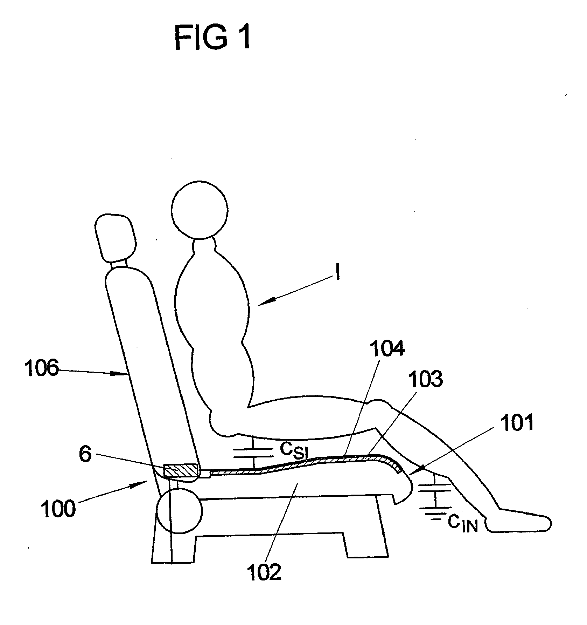

Figur 1 zeigt einen Kraftfahrzeugsitz 100, der ein auf einem Sitzuntergestell vorgesehenes Sitzkissen 101 sowie eine am Sitzuntergestell (klappbar) angelenkte Rückenlehne 106 aufweist, so dass ein auf dem Fahrzeugsitz befindlicher Fahrzeuginsasse I einerseits auf dem Sitzkissen 101 sitzt und sich andererseits mit seinem Rücken an der Rückenlehne 106 abstützen kann. Das Sitzkissen 101 umfasst z.B. ein Polster 102 und einen Bezug 104, wobei hier im Bereich der Sitzfläche des Sitzkissens 101 zwischen dem Sitzpolster 102 und dem Überzug 104 eine Sensormatte 103 angeordnet ist, die mindestens ein kapazitives Sensorelement aufweist. Hierzu kann in die Sensormatte ein erstes elektrisch leitfähiges Element, nachfolgend einfach als erstes Leiterelement bzw. als erster elektrischer Leiter bezeichnet, integriert sein, das eine Elektrode des kapazitiven Sensorelementes bildet und das mit einer Auswerteeinheit 6 verbunden ist, um die Kapazität zwischen der Sensormatte 103, genauer dem mindestens einen auf der Sensormatte 103 angeordneten kapazitiven Sensorelement (Elektrode), und einem Referenzpotential des den Fahrzeugsitz 100 enthaltenden Fahrzeugs bestimmen zu können.

Die Auswerteeinheit 6 kann wiederum mit einem (nicht dargestellten) Steuergerät zusammenwirken, das in Abhängigkeit von der Belegung des Fahrzeugsitzes mit einem Insassen I und gegebenenfalls in Abhängigkeit von der Größe und dem Gewicht des Insassen sowie in Abhängigkeit davon, ob der entsprechende Insasse unmittelbar auf dem Fahrzeugsitz 100 sitzt oder ob es sich hierbei um ein von einem Kindersitz aufgenommenes Kleinkind handelt, zugeordnete Sicherheitseinrichtungen des Fahrzeugsitzes, wie z. B. einen Airbag, aktiviert oder deaktiviert.

Bei einer Anordnung der in Figur 1 gezeigten Art wird die Kapazität zwischen der Sensormatte 103 und dem Referenzpotential im Wesentlichen bestimmt durch die Kombination zweier Kapazitäten, nämlich der Kapazität C_{SI} zwischen der Sensormatte 103 und dem Fahrzeuginsassen I sowie der Kapazität C_{IN} zwischen dem Fahrzeuginsassen und dem Referenzpotential. Hinsichtlich geeigneter Möglichkeiten, den Fahrzeuginsassen I so an das Referenzpotential zu koppeln, dass eine besonders genaue Bestimmung der Belegung des Fahrzeugsitzes 100 ermöglicht wird, sowie hinsichtlich der (Kapazitäts-)Messung sei für weitere Einzelheiten auf die US 6,563,231 B1 verwiesen.

Vorliegend geht es insbesondere um die Ausgestaltung des elektrischen Leiters, welcher die Elektrode der Sensormatte 103 bildet, auf welche die für die Ermittlung der Sitzbelegung notwendigen Kapazitätsmessungen bezogen werden.

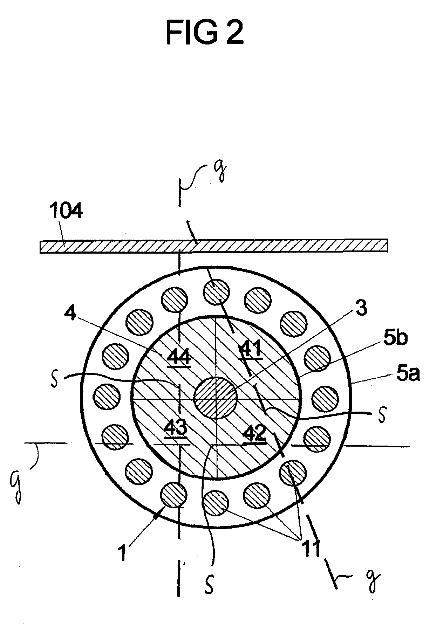

Gemäß der Querschnittsdarstellung der Figur 2 ist ein als Bestandteil einer Sensormatte 103 unterhalb eines Sitzbezuges 104 angeordneter erster elektrischer Leiter, welcher ein kapazitives Sensorelement bzw. eine Elektrode einer Sensormatte bildet, als ein Außenleiter ausgeführt, der ein zur Definition bzw. Bildung eines elektrischen Referenzpotentiales dienendes elektrischen Referenzleiterelement (nachfolgend der Einfachheit halber als Referenzleiter 3 bezeichnet) als Innenleiter aufnimmt und hüllenartig (vollständig) umschließt. Der Referenzleiter 3 als Innenleiter verläuft dabei längserstreckt (senkrecht zur Blattebene der Figur 2) und der das kapazitive Sensorelement bildende erste Leiter 1 verläuft (ebenfalls senkrecht zur Blattebene der Figur 2) entlang des Referenzleiters 3. Konkret bilden der erste Leiter 1 als Außenleiter und der Rferenzleiter 3 als Innenleiter gemäß der Konfiguration der Figur 2 eine Anordnung nach Art eines geschirmten Leiters, z.B. eines Koaxialkabels, mit dem Innenleiter als Seele und dem Außenleiter als äußerer Hülle. Der Referenzleiter 3, der als ein (sitzintegriertes) Referenzpotentialelement dient, welches (z.B. anstelle des häufig hierfür vorgesehenen Fahrzeugbodens) ein Referenzpotential (für Kapazitätsbestimmungen) bildet/definiert, kann dabei vorliegend gleichzeitig als ein (durch Bestromung elektrisch betreibbarer) Heizleiter (zum Beheizen des Sitzes 100 bzw. des Sitzkissens 101) ausgebildet vorgesehen sein. Die Sensormatte 103 bildet dann zugleich eine Heizmatte.

Der Referenzleiter 3 und der erste Leiter 1 sind dabei derart voneinander beabstandet, dass jede beliebige Gerade g (wie in Figur 2 gestrichelt angedeutet), welche sich in der Querschnittsebene der Sensorbaugruppe erstreckt, die den erste Leiter 1 und den Referenzleiter 3 schneidet, unabhängig von der räumlichen Orientierung der Geraden g in der Querschnittsebene, durch Parallelverschiebung in der Querschnittsebene in eine Lage bringbar ist, in der sie eine Kurvensekante s des ersten Leiters 1 bildet (also zwei in der Quereschnittsebene voneinander beabstandete Punkte des ersten Leiters 1 miteinander verbindet), ohne den Referenzleiter 3 zu schneiden.

Der Referenzleiter 3 ist von einem Isolator bzw. Dielektrikum 4 umgeben, welches sich zwischen dem Referenzleiter 3 als Innenleiter und dem ersten Leiter 1 als Außenleiter erstreckt und welches im Ausführungsbeispiel zu dem äußeren ersten Leiter 1 hin von einer (feuchtigkeitsdichten) Schutzhülle 5b umgeben ist. Als Heizleiter dient der Referenzleiter 3 zugleich zur Erzeugung von Wärme bei Bestromung mit elektrischem Strom, so dass hierdurch z.B. die Sitzfläche eines Sitzkissens beheizt werden kann. Das Material des Dielektrikums 4 ist hierbei so gewählt, dass ein hinreichender Teil der im Heizleiter 3 erzeugten Wärme (durch das Dielektrikum 4 hindurch austreten kann und) zur Beheizung des Sitzkissens 101 zur Verfügung steht.

An den Rferenzleiter 3 und das Dielektrikum 4, hier umgeben von einer Schutzhülle 5b, schließt sich (radial) nach außen der als hüllenartiger Außenleiter ausgeführte erste Leiter 1 an, der durch ein leitfähiges Material, vorliegend in Form eines Leitungsgeflechtes 11 oder alternativ in Form einer elektrisch leitfähigen Folie oder einer Leiterbahn, gebildet wird. An der Außenseite des äußeren ersten Leiters 1 kann ebenfalls eine (feuchtigkeitsdichte) Schutzhülle 5a vorgesehen sein.

Im Ergebnis bilden bei Anwesenheit eines Insassen I auf dem Sitz 100 aus Figur 1 das kapazitive Sensorelement (erster Leiter 1) und der Insasse I bzw. dessen dem Sensorelement zugewandte Köperpartie einen ersten Kondensator (der Kapazität C_{SI}) und der Insasse I sowie ein das Referenzpotential definierendes Element (hier der Referenzleiter 3) einen zweiten Kondensator (der Kapazität C_{IN}). Die beiden Kondensatoren sind näherungsweise in Reihe geschaltet.

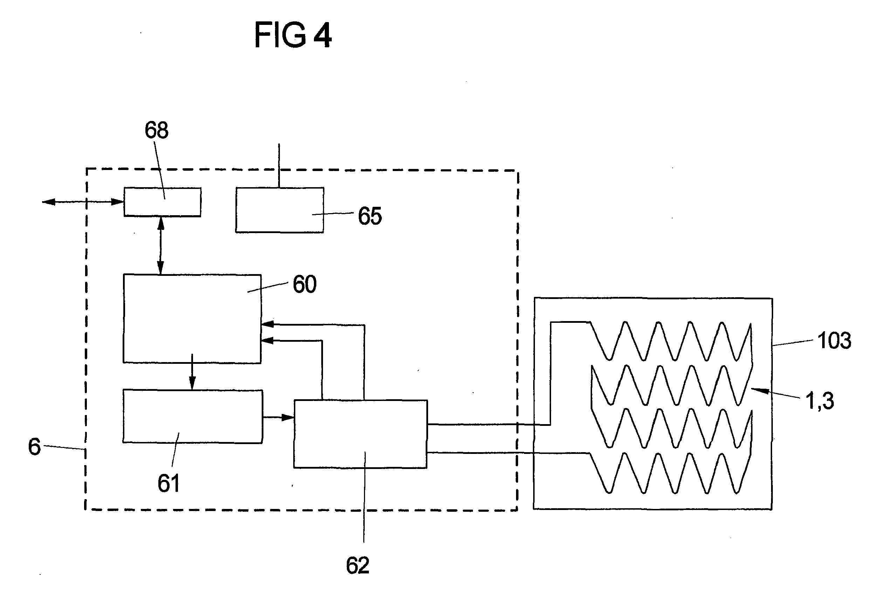

Die Auswerteeinheit 6 ist an die Sensorbaugruppe 1, 3 angeschlossen und kann eine Messgröße (z.B. einen Messstrom) bzw. eine Änderung einer Messgröße als Folge einer durch einen Fahrzeuginsassen I erfolgten kapazitiven Kopplung zwischen dem kapazitiven Sensorelement (erster Leiter 1) und dem Referenzpotential (definiert durch den Referenzleiter 3) erfassen. Konkret können z.B. die Stärke, eine Frequenz, die Amplitude und/oder die Phase eines Messstromes bestimmt werden. Für eine mögliche konkrete Ausgestaltung einer Auswerteeinheit 6 sei auf Figur 4 und die zugehörige Beschreibung verwiesen.

In einer Ausgestaltung ist das den Referenzleiter 3 als Innenleiter umgebende Dielektrikum 4 einerseits hinreichend starr ausgestaltet, so dass es sich unter den im Normalbetrieb der Sensoranordnung auftretenden Kräften bzw. Drücken nicht deformieren lässt. Unter den im Normalbetrieb auftretenden Kräften und Drücken werden dabei insbesondere solche verstanden, die von einem auf dem Fahrzeugsitz 100 sitzenden Fahrzeuginsassen I aufgebracht werden, vergleiche Figur 1. In diesem Fall sorgt das Dielektrikum 4 dafür, dass der (radiale) Abstand zwischen dem ersten Leiter 1 als Außenleiter und dem Referenzleiter 3 als Innenleiter unabhängig von der Belegung des entsprechenden Fahrzeugsitzes stets konstant bleibt, so dass Kraft- bzw. Druckeinwirkung die resultierende Kapazität (unter Verwendung des Außenleiters 1 als kapazitivem Sensorelement) nicht substantiell beeinflusst.

Andererseits besteht die Möglichkeit, für das Dielektrikum 4 gezielt ein (isolierendes) Material auszuwählen, das sich in Abhängigkeit von dem Gewicht eines auf dem Fahrzeugsitz 100 sitzenden Fahrzeuginsassen verformt. So kann das Material des Dielektrikums 4 beispielsweise derart gewählt sein, dass es unter der Wirkung des Gewichtes eines Kindersitzes einschließlich eines darin befindlichen Kleinkindes nicht verformt wird, sondern eine substantielle Verformung erst ab einer Kraft- bzw. Druckschwelle auftritt, die oberhalb des Gewichtes eines Kindersitzes mit Kleinkind liegt und beispielsweise dem Gewicht eines kleinen weiblichen Fahrgastes (sogenannte 5%-Frau) entspricht.

Da mit einer Verformung des Dielektrikums 4 eine Änderung des Abstandes zwischen dem ersten Leiter 1 als Außenleiter und dem Referenzleiter 3 als Innenleiter einhergeht, ändern sich dementsprechend auch die Werte der auf den ersten Leiter 1 als kapazitives Sensorelement bezogenen Kapazitäten. Im Ergebnis kann also die Sensorbaugruppe bei geeigneter Wahl des Dielektrikums 4 ergänzend als ein druckempfindlicher Sensor (Drucksensor) ausgestaltet werden, um hierdurch zusätzliche Informationen über einen auf dem zugeordneten Fahrzeugsitz 100 befindlichen Fahrzeuginsassen zu gewinnen.

Bei Bedarf kann auch eine orts- bzw. richtungsabhängige Druckempfindlichkeit der Sensorbaugruppe erreicht werden, etwa indem für unterschiedliche Bereiche 41, 42, 43, 44 des Dielektrikums 4 unterschiedliche (isolierende) Materialien verwendet werden. Je nachdem in welchen Bereichen 41, 42, 43, 44 Materialien mit vergleichsweise großer Komprimierbarkeit (vergleichsweise großer Kompressibilität bzw. kleinem Kompressionsmodul) sowie Materialien mit vergleichsweise geringer Komprimierbarkeit (vergleichsweise kleiner Kompressibilität bzw. großem Kompressionsmodul) verwendet werden, lässt sich erreichen, dass Abstandsänderungen zwischen dem ersten Leiter 1 als Außenleiter und dem Referenzleiter 3 als Innenleiter von dem Ort und/oder der Richtung einer an der Sensorbaugruppe angreifenden Kraft abhängen.

Es kann dabei auch vorgesehen sein, als Dielektrikum ein Material zu verwenden, das mit einer gewissen zeitlichen Verzögerung (durch Deformation) auf Druckeinwirkung reagiert, so dass durch zeithabhängige Messung der Kapazität bzw. hiermit verknüpfter (also von der Kapazität abhängiger) Messgrößen Druckeinflüsse beobachtet, ausgewertet und berücksichtigt werden können. Eine geeignet gewählte Reaktionsverzögerung ermöglicht insbesondere ein phasenweises Messen, wobei etwa zunächst (vor der verzögerten Deformation des Dielektrikums als Folge einer Krafteinwirkung) rein kapazitive Kopplungsänderungen - als Folge einer Belegung des Sitzes - erfasst werden und anschließend (bei bzw. nach Deformation des Dielektrikums) der Einfluss einer Deformation des Dielektrikums auf die kapazitive Kopplung erfasst wird, wodurch zusätzliche Daten für die Erfassung der Sitzbelegung sowie die Unterscheidung zwischen unterschiedlich großen/schweren Fahrzeuginsassen zur Verfügung stehen.

Das Material des Dielektrikums 4 kann so gewählt werden, dass es sich durch Temperaturänderungen, also durch eine Änderung der Umgebungstemperatur und/oder durch eine Änderung der vom Referenz-/Heizleiter 3 im Betrieb erzeugten Temperatur - in Abhängigkeit davon, ob eine Temperaturerhöhung oder eine Temperaturabsenkung vorliegt - derart ausdehnt bzw. zusammenzieht, dass sich die Abstände zwischen den Komponenten der Sensorbaugruppe, insbesondere zwischen dem als kapazitives Sensorelement dienenden äußeren, ersten Leiter 1 und dem Referenz-/Heizleiter 3 ändern. Die hiermit verbundenen Auswirkungen auf die unter vorgegebenen Bedingungen (Belegung oder Nicht-Belegung des Sitzes sowie ggf. Konstitution eines den Sitz belegenden Insassen) ermittelte Kapazität erlauben einen Rückschluss auf die Umgebungstemperatur bzw. - bei Betrieb des Referenzleiters 3 als Heizleiter - auf die vom Heizleiter erzeugte Temperatur. Hiermit lassen sich zum einen Einrichtungen eines Kraftfahrzeugs, wie z. B. die Heizeinrichtung selbst oder ein Klimagerät, steuern bzw. regeln und zum anderen Temperatureinflüsse auf die Sensorbaugruppe geeignet berücksichtigen.

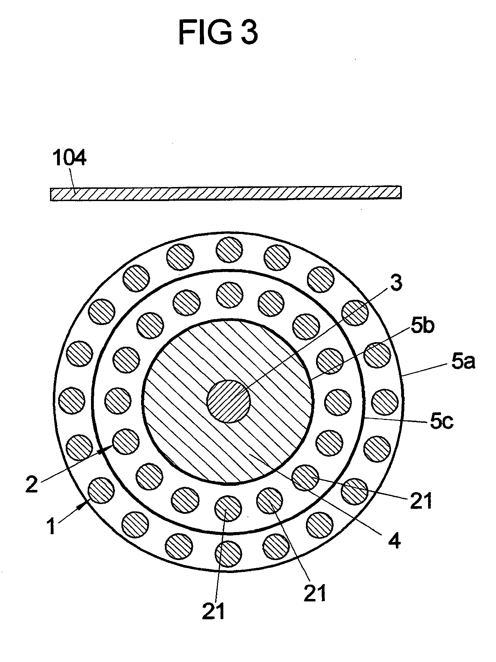

Figur 3 zeigt eine Weiterbildung der Sensorbaugruppe aus Figur 2 als Ausführung der Erfindung, gemäß der sich zwischen dem ersten Leiter 1 als Außenleiter und dem Referenzleiter 3 als Innenleiter ein zusätzlicher zweiter Leiter 2 erstreckt, der hier (ebenfalls) als Leitungsgeflecht 21 ausgebildet ist und der den Referenzleiter 3 und das Dielektrikum 4 hüllenartig umgibt. Hierdurch lässt sich der als kapazitives Sensorelement dienende erste Leiter 1 in Form eines Außenleiters gegenüber dem Referenzleiter 3 in Form eines Innenleiters abschirmen, so dass Abstandsänderungen zwischen dem ersten Leiter 1 und dem Referenzleiter 3 keine substantielle Rückwirkung auf die resultierende Kapazität haben. Der durch den zweiten Leiter 2 gebildete Schirm kann dabei als ein so genannter potentialgesteuerter Schirm ("driven shield") ausgebildet sein.

Weiterhin kann zwischen dem ersten Leiter 1 und dem zweiten Leiter 2 eine weitere (gegebenenfalls feuchtigkeitsdichte) Schutzhülle 5c verlaufen. Von den insgesamt drei in Figur 3 gezeigten Schutzhüllen 5a, 5b, 5c können dabei in der Praxis je nach Bedarf eine oder mehrere vorgesehen sein.

Zusammenfassend ist die Sensorbaugruppe gemäß Figur 3 nach Art eines Triaxialkabels ausgebildet, mit dem Rferenzleiter 3 als Seele, dem ersten Leiter 1 als äußerer Hülle und dem zweiten Leiter 2 als mittlerer Hülle, die den Referenzleiter 3/Seele umschließt und die wiederum von der durch den ersten Leiter 1 gebildeten äußeren Hülle umschlossen wird.

Figur 4 zeigt eine Sensorbaugruppe 1, 3 der in Figur 2 bzw. 3 im Querschnitt dargestellten Art als Bestandteil einer Sensormatte 103 zusammen mit einer nachgeordneten Auswerteeinheit 6 zu Auswertung von der Sensorbaugruppe 1, 3 erzeugter Ausgangssignale.

Die Auswerteeinheit 6 kann zum einen dazu dienen, in einfacher Weise die Kapazität der Sensormatte 103 bezogen auf das Referenzpotential zu ermitteln, welche bei Belegung des entsprechenden Fahrzeugsitzes 100 mit einem Fahrzeuginsassen I, vergleiche Figur 1, bestimmt wird durch die Verschaltung (z.B. Reihenschaltung) der Kapazität C_{SI} zwischen der Sensormatte 103 und dem Fahrzeuginsassen I sowie der Kapazität C_{IN} zwischen dem Fahrzeuginsassen I und dem Referenzpotential.

Nach der konkreten in figur 4 gezeigten Ausgestaltung wird der erste Leiter 1 (Außenleiter) der Sensorbaugruppe als kapazitives Sensorelement mit einem Wechselstrom, z. B. einem Sinussignal einer definierten Frequenz, etwa von 120 kHz, beaufschlagt. Hierzu ist der Auswerteeinheit 6 eine Energieversorgungseinrichtung 65 zugeordnet; und es wird in einer Signalerzeugungseinrichtung 61 ein (sinusförmiger) Wechselstrom mit definierter Phase und Amplitude generiert und der Sensormatte 103 bzw. der Sensorbaugruppe 1, 3 (genauer dem mindestens einen ein kapazitives Sensorelement bildenden Außenleiter 1) zugeführt. Die Erzeugung des besagten Sinussignals kann durch einen Mikroprozessor 60 der Auswerteeinheit 6 gesteuert werden.

Mittels einer Messeinrichtung 62, die in eine an die Sensorbaugruppe 1, 3 angeschlossene elektrische Verbindungsleitung integriert ist und die im Ausführungsbeispiel zwischen der Signalerzeugungseinrichtung 61 und der Sensorbaugruppe 1, 3 bzw. der Sensormatte 103 liegt, wird der tatsächlich anliegende Wechselstrom gemessen und das Messergebnis dem Mikroprozessor 60 der Auswerteeinheit 6 zugeführt. Durch den Vergleich von Parametern des in der Signalerzeugungseinrichtung 61 erzeugten Wechselstroms, wie z. B. Amplitude und Phase, mit den an der Messeinrichtung 62 tatsächlich gemessenen entsprechenden Parametern, also z. B. Amplitude und Phase, lassen sich die durch die Sensormatte 103 bzw. Sensorbaugruppe 1, 3 und deren kapazitive Wechselwirkung mit der Umgebung (z.B. mit einem Fahrzeuginsassen) bewirkten Abweichungen in den besagten Parametern bestimmen.

Hierzu werden z.B. der Wirkstromanteil (also der mit der zugrundeliegenden Wechselspannung phasengleiche Anteil bzw. Realteil des Wechselstromes), insbesondere als Grundlage für die Bestimmung einer Phasenverschiebung, und/oder der Blindstromanteil (Imaginärteil des Wechselstromes) und/oder der Quadraturanteil bzw. Effektivwert des Stromes, insbesondere als Grundlage für die Bestimmung der Amplitude, ermittelt.

Insbesondere aus Amplitudenabweichungen kann dabei auf Kapazitäten der Sensorbaugruppe gegenüber einem Bezugspotential ("Referenzpotential") rückgeschlossen werden und aus Abweichungen der Phase auf mögliche Kriechströme, welche auf Feuchtigkeit bzw. Nässe im Sitz beruhen.

Hierdurch lassen sich bei der Auswertung gemessener Kapazitäten bzw. hiermit in Beziehung stehender Messgrößen zur Ermittlung der Belegung eines Sitzes, z. B. zur Unterscheidung der Zustände "nicht belegt", "unmittelbar von einem Fahrzeuginsassen belegt" sowie "von einem in einem Kindersitz befindlichen Kleinkind belegt", zusätzlich Feuchtigkeit und Nässe im Sitz berücksichtigen, was Fehlinterpretationen der Messergebnisse im Hinblick auf die Sitzbelegung verhindert.

Über eine Schnittstelle 68 können die über die Sitzbelegung gewonnenen Informationen an eine Steuereinrichtung weitergeleitet werden, um in Abhängigkeit hiervon Fahrzeugsysteme, insbesondere Insassenschutzsysteme, wie z. B. ein Airbagsystem, zu steuern.

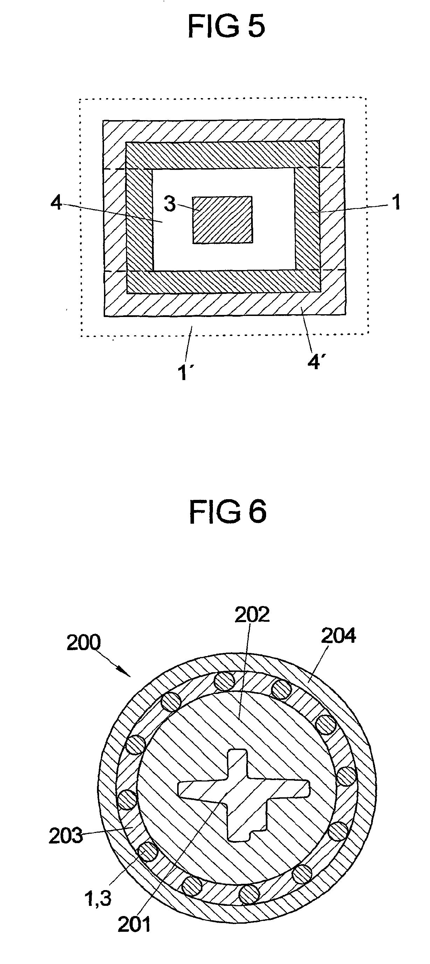

Figur 5 zeigt eine kapazitive Sensorbaugruppe, die ein kapazitives Sensorelement 1 in Form eines Außenleiters umfasst, welches einen (ggf. als Heizleiter dienenden) Referenzleiter 3 als Innenleiter umgibt, wobei sich zwischen dem Referenzleiter 3 als Innenleiter und dem kapazitiven Sensorelement 1 als Außenleiter ein Dielektrikum erstreckt, im Querschnitt. Die in Figur 5 gezeigte Anordnung, insbesondere deren erster Leiter 1 als Außenleiter sowie der Referenzleiter 3 und das Dielektrikum 4, erstrecken sich dabei senkrecht zur Blattebene der Figur 5.

Die Anordnung entspricht insoweit vom prinzipiellen Aufbau der Anordnung aus Figur 2, mit dem Unterschied, dass es sich vorliegend um ein aus Schichten aufgebautes System handelt, das - nach Art eines Flachleiters - aus einer Mehrzahl aufeinander aufgebrachter (z. B. auflaminierter) Schichten besteht, wie nachfolgend noch näher erläutert werden wird.

In Figur 5 ist dabei weiterhin angedeutet, dass die Anordnung aus dem äußeren, ersten Leiter 1, dem inneren Referenzleiter 3 sowie dem dazwischen liegenden Dielektrikum 4 außen von einem weiteren Dielektrikum 4' umgeben sein kann, an das sich wiederum ein elektrisch leitfähiges Element 1' anschließen kann usw. So können grundsätzlich n-fach nach außen hin elektrische Leiter 1, 1', ... aufeinander folgen, wobei diese jeweils durch eine geeignete isolierende Schicht voneinander getrennt sind.

Durch gestrichelte Linie sind in Figur 5 beispielhaft Grenzflächen zwischen aufeinander angeordneten (aufeinander laminierten) Schichten angedeutet, die die Sensorbaugruppe aus Figur 5 bilden.

Figur 6 zeigt schließlich einen Querschnitt durch ein Lenkrad 200 im Bereich des Lenkradkranzes mit einer dort angeordneten kapazitiven Sensorbaugruppe 203.

Gemäß Figur 6 umfasst das Lenkrad 200 im Bereich des Kranzes ein Skelett 201 umgeben von einer Umhüllung 202, z. B. einem Lenkradschaum, und mit einem die äußere Oberfläche des Lenkradkranzes definierenden Bezug 204, z. B. aus Leder. Jenseits der Umhüllung 202, jedoch unterhalb der äußeren Oberfläche (definiert durch den Bezug 204) ist die kapazitive Sensorbaugruppe 203 angeordnet, die eine Vielzahl Anordnungen 1, 3 der in den Figuren 2 oder 3 oder 5 gezeigten Art umfasst, also jeweils mit einem als Außenleiter ausgebildeten kapazitiven Element und einem Referenzleiter/Heizleiter als innerem Leiter.

## Patentansprüche

1. Kapazitive Sensorbaugruppe für ein Kraftfahrzeug, mit
- einem kapazitiven Sensorelement, das mindestens ein erstes elektrisches Leiterelement (1) umfasst und das an eine Auswerteeinheit (6) anzuschließen ist, welche mindestens eine Messgröße in Abhängigkeit von der kapazitiven Ankopplung des kapazitiven Sensorelementes an die Umgebung erfasst und auswertet, und
- einem Referenzleiterelement (3), das ein elektrisches Referenzpotential definiert und das von dem ersten elektrischen Leiterelement (1) beabstandet angeordnet ist,
wobei das erste elektrische Leiterelement (1) als äußeres Leiterelement ausgeführt ist, das das Referenzleiterelement (3) als Innenleiter umgibt,
**dadurch gekennzeichnet,**
**dass** zwischen dem ersten Leiterelement (1) als äußeres Leiterelement und dem Referenzleiterelement (3) als Innenleiter zusätzlich ein zweites Leiterelement (2) verläuft, wobei das erste und zweite Leiterelement (1, 2) sowie das Referenzleiterelement (3) einen Triaxialkabelaufbau bilden.

2. Sensorbaugruppe nach Anspruch 1, **dadurch gekennzeichnet, dass** das erste Leiterelement (1) das Referenzleiterelement (3) in einer Querschnittsebene der Sensorbaugruppe, die das erste Leiterelement (1) und das Referenzleiterelement (3) schneidet, vollständig umgibt, insbesondere als geschlossene Kurve umschließt.

3. Sensorbaugruppe nach Anspruch 2, **dadurch gekennzeichnet, dass** das Referenzleiterelement (3) und das erste Leiterelement (1) derart voneinander beabstandet sind, dass jede beliebige Gerade (g), welche sich in der Querschnittsebene der Sensorbaugruppe erstreckt, die das erste Leiterelement (1) und das Referenzleiterelement (3) schneidet, unabhängig von der räumlichen Orientierung der Geraden (g) in der Querschnittsebene, durch Parallelverschiebung in der Querschnittsebene in eine Lage bringbar ist, in der sie eine Kurvensekante (s) des ersten Leiterelementes (1) bildet, ohne das Referenzleiterelement (3) zu schneiden.

4. Sensorbaugruppe nach einem der vorhergehenden Ansprüche, **dadurch gekennzeichnet, dass** das erste Leiterelement (1) als äußeres Leiterelement und das Referenzleiterelement (3) als Innenleiter einen koaxialen Kabelaufbau bilden.

5. Sensorbaugruppe nach einem der vorhergehenden Ansprüche, **dadurch gekennzeichnet, dass** das erste Leiterelement (1) als äußeres Leiterelement und das Referenzleiterelement (3) als Innenleiter einen geschirmten Kabelaufbau bilden.

6. Sensorbaugruppe nach Anspruch 1, **dadurch gekennzeichnet, dass** das zweite Leiterelement (2) das erste Leiterelement (1) und das Referenzleiterelement (3) gegeneinander abschirmt, wobei insbesondere das zweite Leiterelement (2) als potentialgesteuerter Schirm ausgeführt ist.

7. Sensorbaugruppe nach einem der vorhergehenden Ansprüche, **dadurch gekennzeichnet, dass** das Referenzleiterelement (3) zugleich als Heizleiter zum Beheizen mindestens einer Fahrzeugkomponente (100, 101, 106, 200) dient.

8. Sensorbaugruppe nach einem der vorhergehenden Ansprüche, **dadurch gekennzeichnet, dass** der erste Leiter (1) mit einem Wechselstrom beaufschlagt ist und eine Messeinrichtung (62) zur Bestimmung von Parametern des Wechselstromes vorgesehen ist, um die Einwirkung der Sensorbaugruppe (1, 3) auf den Wechselstrom zu ermitteln.

9. Sensorbaugruppe nach einem der vorhergehenden Ansprüche, **dadurch gekennzeichnet, dass** die Sensorbaugruppe (1, 3) Bestandteil einer Sensormatte (103) ist.

10. Sensorbaugruppe nach Anspruch 7 und 9, **dadurch gekennzeichnet, dass** die Sensormatte (103) als Heizmatte zum Beheizen mindestens einer Fahrzeugkomponente (100, 101, 106, 200) dient.

11. Sensorbaugruppe nach einem der vorhergehenden Ansprüche, **dadurch gekennzeichnet, dass** die Sensorbaugruppe (1, 3) weiterhin einen Temperatursensor bildet.

12. Sensorbaugruppe nach einem der vorhergehenden Ansprüche, **dadurch gekennzeichnet, dass** die Sensorbaugruppe ausgebildet und vorgesehen ist zum Einbau in ein Kraftfahrzeugteil, um hiermit die Anwesenheit eines Fahrzeuginsassen an einem bestimmten Sitzplatz zu erkennen.

13. Sensorbaugruppe nach einem der vorhergehenden Ansprüche, **dadurch gekennzeichnet, dass** die Sensorbaugruppe ausgebildet und vorgesehen ist zum Einbau in einen Kraftfahrzeugsitz (100) und/oder ein Lenkrad (200) und/oder ein Sicherheitsgurtsystem.

14. Kraftfahrzeugsitz mit einem Sitzgestell, mindestens einem am Sitzgestell vorgesehenen Sitzpolster (102) und einer Sensorbaugruppe nach einem der Ansprüche 1 bis 12, die zur Erkennung einer Sitzbelegung dient.

15. Kraftfahrzeuglenkrad mit einem Lenkradkörper und mindestens einer am Lenkradkörper vorgesehenen Sensorbaugruppe nach einem der Ansprüche 1 bis 12, die zur Erkennung einer Handauflage eines Fahrzeugführers (I) am Lenkrad dient.

## Claims

1. Capacative sensor assembly for a motor vehicle with
- a capacitive sensor element, which comprises at least one first electrical conductor element (1) and which is to be connected to an evaluation unit (6), which detects and evaluates at least one measured value depending on the capacitive coupling of the capacitive sensor element to its surrounding, and
- a reference conductor element (3), which defines an electrical reference potential and which is being arranged with a distance from the first electrical conductor element (1),
wherein the first electrical conductor element (1) is designed as an outer conductor element which surrounds the reference conductor element (3) as inner conductor,
**characterized in that**
a second conductor element (2) continues additionally between the first conductor element (1) as outer conductor and the reference conductor element (3) as inner conductor, wherein the first and the second conductor element (1, 2) as well as the reference conductor element (3) form a triaxial cable design.

2. Sensor assembly according to claim 1, **characterized in that** the first conductor element (1) completely surrounds the reference conductor element (3) in a cross sectional plane of the sensor assembly, which intersects the first conductor element (1) and the reference conductor element (3), particularly the first conductor element (1) encloses the reference conductor element (3) as a closed curve.

3. Sensor assembly according to claims 2 **characterized in that** the reference conductor element (3) and the first conductor element (1) are distanced from each other such that any straight line (g), which extends in the cross-sectional plane of the sensor assembly, which intersects the first conductor element (1) and the reference conductor element (3), can be brought independent on the spatial orientation of the straight line (g) in the cross-sectional plane by parallel displacement in the cross-sectional plane into a position in which it forms a curve secant (s) of the first conductor element (1) without intersecting the reference conductor element (3).

4. Sensor assembly according to one of the proceeding claims, **characterized in that** the first conductor element (1) as outer conductor element and the reference conductor element (3) as inner conductor form a coaxial cable design.

5. Sensor assembly according to one of the proceeding claims, **characterized in that** the first conductor element (1) as outer conductor element and the reference conductor element (3) as inner conductor form a shielded cable design.

6. Sensor assembly according to claim 1, **characterized in that** the second conductor element (2) shields the first conductor element (1) and the reference conductor element (3) against each other, wherein particularly the second conductor element (2) is designed as potential controlled shield.

7. Sensor assembly according to one of the proceeding claims, **characterized in that** the reference conductor element (3) serves at the same time as heating conductor for heating at least one vehicle component (100, 101, 106, 200).

8. Sensor assembly according to one of the proceeding claims, **characterized in that** the first conductor (1) is supplied with an alternating current and a measuring device (62) is provided for determining parameters of the alternating current in order to determine the effect of the sensor assembly (1, 3) on the alternating current.

9. Sensor assembly according to one of the proceeding claims, **characterized in that** the sensor assembly (1, 3) is a part of a sensor mat (103).

10. Sensor assembly according to claim 7 and 9, **characterized in that** the sensor mat (103) serves as a heating mat for heating at least one vehicle component (100, 101, 106, 200).

11. Sensor assembly according to one of the proceeding claims, **characterized in that** the sensor assembly (1, 3) forms furthermore a temperature sensor.

12. Sensor assembly according to one of the proceeding claims, **characterized in that** the sensor assembly formed and provided for being assembled into a motor vehicle part in order to recognize herewith the presence of a vehicle occupant in a certain seat.

13. Sensor assembly according to one of the proceeding claims, **characterized in that** the sensor assembly is formed and provided for being assembled into a motor vehicle seat (100) and/or a steering wheel (200) and/or a safety belt system.

14. Motor vehicle seat with a seat frame, at least one seat cushion (102) provided at the seat frame and a sensor assembly according to one of the claims 1 to 12, which serves the recognition of a seat occupation.

15. Motor vehicle steering wheel with a steering wheel body and at least one sensor assembly according to one of the claims 1 to 12 provided on the steering wheel body, which serves for recognizing a hand rest of a vehicle driver (I) on the steering wheel.

## Revendications

1. Module capteur capacitif pour un véhicule automobile, comportant
- un élément capteur capacitif, qui comporte au moins un premier élément conducteur (1) électrique et qui est destiné à être raccordé à une unité d'analyse (6) qui enregistre et analyse au moins une grandeur de mesure en fonction du couplage capacitif de l'élément capteur capacitif avec l'environnement, et
- un élément conducteur de référence (3) qui définit un potentiel de référence électrique et qui est disposé à distance du premier élément conducteur (1) électrique,
ledit premier élément conducteur (1) électrique étant réalisé sous la forme d'un élément conducteur externe, qui entoure l'élément conducteur de référence (3) réalisé sous forme de conducteur interne,
**caractérisé en ce que**
un deuxième élément conducteur (2) s'étend de plus entre le premier élément conducteur (1) sous forme d'élément conducteur externe et l'élément conducteur de référence (3) sous forme d'élément conducteur interne, ledit premier et ledit deuxième élément conducteur (1, 2), ainsi que l'élément conducteur de référence (3), formant une structure de câble triaxiale

2. Module capteur selon la revendication 1, **caractérisé en ce que** le premier élément conducteur (1) entoure complètement, en particulier sous forme de courbe fermée, l'élément conducteur de référence (3) dans un plan transversal du module capteur, qui coupe le premier élément conducteur (1) et l'élément conducteur de référence (3).

3. Module capteur selon la revendication 2, **caractérisé en ce que** l'élément conducteur de référence (3) et le premier élément conducteur (1) sont situés à distance l'un de l'autre de telle sorte que chaque droite (g) quelconque, qui s'étend dans le plan transversal du module capteur qui coupe le premier élément conducteur (1) et l'élément conducteur de référence (3), peut être amenée, indépendamment de l'orientation dans l'espace de la droite (g) dans le plan transversal, par coulissement parallèle dans le plan transversal dans une position dans laquelle elle forme une sécante de courbe (s) du premier élément conducteur (1) sans couper l'élément conducteur de référence (3).

4. Module capteur selon l'une quelconque des revendications précédentes, **caractérisé en ce que** le premier élément conducteur (1) sous forme d'élément conducteur externe et l'élément conducteur de référence (3) sous forme d'élément conducteur interne forment une structure de câble coaxiale.

5. Module capteur selon l'une quelconque des revendications précédentes, **caractérisé en ce que** le premier élément conducteur (1) sous forme d'élément conducteur externe et l'élément conducteur de référence (3) sous forme d'élément conducteur interne forment une structure de câble blindée.

6. Module capteur selon la revendication 1, **caractérisé en ce que** le deuxième élément conducteur (2) protège le premier élément conducteur (1) et l'élément conducteur de référence (3) l'un par rapport à l'autre, en particulier le deuxième élément conducteur (2) étant réalisé sous la forme d'un blindage avec répartition des potentiels.

7. Module capteur selon l'une quelconque des revendications précédentes, **caractérisé en ce que** l'élément conducteur de référence (3) fait fonction, en même temps, de conducteur chauffant destiné à chauffer au moins un composant (100, 101, 106, 200) du véhicule.

8. Module capteur selon l'une quelconque des revendications précédentes, **caractérisé en ce que** le premier conducteur (1) est alimenté avec un courant alternatif et il est prévu un dispositif de mesure (62) destiné à déterminer les paramètres du courant alternatif, afin de déterminer l'influence du module capteur (1, 3) sur le courant alternatif.

9. Module capteur selon l'une quelconque des revendications précédentes, **caractérisé en ce que** le module capteur (1, 3) fait partie intégrante d'une nappe de détection (103).

10. Module capteur selon les revendications 7 et 9, **caractérisé en ce que** la nappe de détection (103) fait fonction de nappe de chauffage destinée à chauffer au moins un composant (100, 101, 106, 200) du véhicule.

11. Module capteur selon l'une quelconque des revendications précédentes, **caractérisé en ce que** le module capteur (1, 3) forme, en plus, un capteur de température.

12. Module capteur selon l'une quelconque des revendications précédentes, **caractérisé en ce que** le module capteur est configuré et prévu pour être intégré dans une partie de véhicule automobile, afin de détecter ainsi la présence d'un occupant du véhicule sur un siège déterminé.

13. Module capteur selon l'une quelconque des revendications précédentes, **caractérisé en ce que** le module capteur est configuré et prévu pour être intégré dans un siège automobile (100) et/ou un volant de direction (200) et/ou un système de ceinture de sécurité.

14. Siège automobile, comportant un châssis, au moins un rembourrage de siège (102), prévu sur le châssis du siège, et un module capteur selon l'une quelconque des revendications 1 à 12, qui est destiné à détecter l'occupation d'un siège.

15. Volant de direction d'un véhicule automobile, comportant un corps de volant et au moins un module capteur selon l'une quelconque des revendications 1 à 12, qui est prévu sur le corps de volant et qui est destiné à détecter l'appui des mains d'un conducteur (I) sur le volant de direction.
